# EUROPEAN PATENT SPECIFICATION

(11) **EP 2 784 586 B1**
(45) Date of publication and mention of the grant of the patent: **18.03.2015**
(21) Application number: 13002404.5
(22) Date of filing: 27.03.2013
(51) Int. Cl.: G03F 7/039

(54) **Multidimensionally photopatterned substrates on the basis of monosaccharide derivatives, their oligomers and their polymers and a method of production thereof**
Mehrdimensional photostrukturierte Substrate auf der Grundlage von Monosaccharidderivaten, deren Oligomere und deren Polymere, und Herstellungsverfahren dafür
Substrats à photomotifs multidimensionnels sur la base de dérivés de monosaccharides, leurs oligomères et leurs polymères et procédé de production de celui-ci

(43) Date of publication of application: 01.10.2014
(73) Proprietor: Univerza v Mariboru Fakulteta za strojnistvo, 2000 Maribor (SI); Montanuniversität Leoben, 8700 Leoben (AT); Universität Graz, 8010 Graz (AT)
(72) Inventor: Stana Kleinschek, Karin, 2000 Maribor (SI); Spirk, Stefan, 8042 Graz (AT); Grießer, Thomas, 8010 Graz (AT); Kern, Wolfgang, 8055 Seiersberg (AT); Kargl, Rupert, 8820 Neumarkt (AT); Ribitsch, Volker, 8010 Graz (AT)
(74) Representative: Marn, Jure

(56) References cited:
- EP-A1- 0 848 290
- EP-A1- 1 211 559
- US-A- 5 981 135
- US-A1- 2006 194 144
- RUPERT KARGL ET AL: "Functional Patterning of Biopolymer Thin Films Using Enzymes and Lithographic Methods", ADVANCED FUNCTIONAL MATERIALS, vol. 23, no. 3, 21 January 2013 (2013-01-21), pages 308-315, XP055072734, ISSN: 1616-301X, DOI: 10.1002/adfm.201200607
- MOTOMU TANAKA ET AL: "Selective Deposition of Native Cell Membranes on Biocompatible Micropatterns", JOURNAL OF THE AMERICAN CHEMICAL SOCIETY, vol. 126, no. 10, 1 March 2004 (2004-03-01), pages 3257-3260, XP055072738, ISSN: 0002-7863, DOI: 10.1021/ja038981d

## Description

### Technical field

Surface cellulose film structuring

### Technical problem

The technical problem to be solved by the present invention is the lack of environmentally friendly photoresist compositions. Further problem is the lack of 3-D structuring and the use of a sugar/polysaccharide derivative bearing at least two acid labile groups, the use of hydroxyalkane derivatives as such, which limits the applicability.

### State of the art

Cellulose is a widespread biopolymer because it is a major component of the cell walls of plants. It exhibits remarkable mechanical properties, is highly stable at ambient conditions and shows a high degree of biocompatibility. Therefore, cellulose becomes more and more important e.g. for biotechnological applications or as main component in materials placed in a physiological environment.

Cellulose is insoluble in water and most conventional organic solvents and therefore different strategies must be followed for the creation of cellulose films on surfaces. A common strategy is to use soluble cellulose derivatives which are deposited on surfaces and converted back to cellulose, For many desired applications such as integrated circuits, microstructure implants, waveguides etc. further structuring and processing steps are required to obtain the final micro-structured material. There are many techniques which allow such a microstructuring, for instance well established soft lithography where microstructures are transferred by a soft mold to the cellulose films. This can also be done in combination with enzymes which are immobilized onto the molds, allowing a microstructuring of the films per teaching of R. Kargl et al. Adv. Funct. Mater. 2013, 23, 308-315. There are also photolithographic methods known for the structuring of cellulose and its derivatives which are based on the degradation of cellulose in hard UV-light under ambient atmosphere. According to M. Tanaka et al. J. Am, Chem. Soc. 2004, 126, 3257-3260 in this manner cellulose structures in areas which have not been exposed to radiation can be obtained. Patent US 7122297B2 presents the structuring of photolabile sugars and polysaccharide derivatives using photo acid generators which create an acid upon exposure to radiation (UV, X-ray and the like). More detailed, PAG is added to a sugar/polysaccharide derivative bearing at least two different acid labile groups and a photolithographic 2-D patterning is performed by UV illumination and subsequent dissolution of the unexposed areas. The acid labile groups are claimed to be hydroxyalkane groups which are attached to the sugar/polysaccharide.

There are two major disadvantages of US 7122297B2, namely the use of a sugar/polysaccharide derivative bearing at least two acid labile groups, the use of hydroxyalkane derivatives as such, which limits the applicability and that this system is not capable to perform a 3-D structuring. Also a patterning of the materials using enzymes is not claimed in US 7122297B2.

EP1211559 A1 discloses a twodimensionally patterned substrate on the basis of photoresist, said photoresist comprising a hydroxyalkyl cellulose derivative being modified by esterification of one hydroxyl group of the derivative with pivaloylic acid to obtain the hydrophobe cellulose derivative, said cellulose derivative bearing at least one type of acid labile group and further comprising a 2-photon sensitive photoacid generator.

US2006/194144 A1 discloses a twodimensionally patterned substrate on the basis of substituted oligosaccharides wherein the oligosaccharide is substituted with at least one acid-cleavable -OR group wherein the oligosaccharide is insoluble in water prior to exposure to actinic radiation, said composition the pattern are formed of further comprising a 2-photon sensitive photoacid generator

### Description of invention

Multidimensionally photopatterned substrates on the basis of monosaccharide derivatives, their oligomers and their polymers and a method of production thereof solve above referenced technical problem by use of silylated sugar/polysaccharide derivatives, further 3-D structuring, and use of enzymes to obtain positive and negative resists. The invention is characterized by 2- and 3-dimensionally patterned substrates composed of a photoresist composition on the basis of mono, di-, oligo and polysaccharide derivatives which bear only one type of acid labile group and a photoacid generator (hereinafter PAG) which generates an acid upon exposure to electromagnetic waves and/or charged particle beams, and/or a 2-photon sensitive PAG wherein said substrate is comprised of silyl ether of any of the following: monosaccharide, disaccharide, oligosaccharide, polysaccharide, said substrate changing its refractive index upon conversion to the polysaccharide.

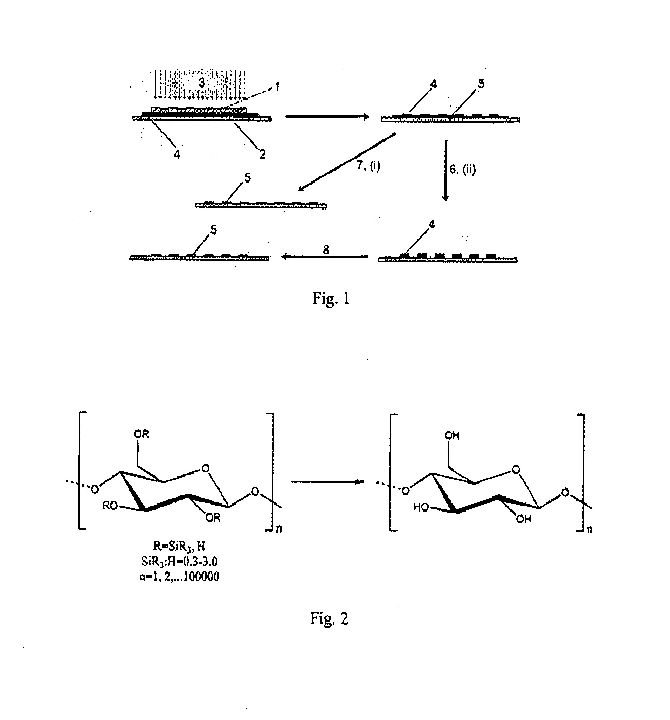

The underlying invention is dealing with mixtures composed of a chemically modified cellulose derivative or any other polysaccharide and PAG which changes its solubility upon exposure with actinic radiation. Films that have been obtained from these mixtures can be structured using photolithography or other types of radiation induced lithography whereby a resolution in the sub-micrometer range can be achieved. The use of 2-photon-absorption-lithography further allows also the preparation of 3-D cellulose/polysaccharide structures via the reaction in the focus of a light beam. The areas that have been exposed to irradiation show a different solubility to those which have not been exposed. As a consequence, a selective removal of the layers in the exposed/non-exposed areas is possible by means of simple dissolution or enzymatic treatment yielding 2-D and 3-D positive and negative resists. A scheme is depicted in Fig. 1. Besides the solubility, also the refractive indices of the exposed areas change significantly.

Figure 1 shows photolithographic mask 1, carrier 2, irradiation 3, TMSC+PAG 4, cellulose 5, enzymatic treatment 6, solvent 7, regeneration 8.

Figure 2 shows the conversion of a cellulose derivative bearing an acid labile group R to cellulose.

The main objective of the present invention is to provide an environmentally friendly photoresist composition which can be 2- and 3-dimensionally micro- and nanostructured with high resolution and sensitivity using electromagnetic waves such as ultraviolet light, far ultraviolet light, vacuum ultraviolet light, X-ray irradiation; and charged particle beams such as ion beam, electron beam, and the like; and 2-photon-absorption. The photoresist composition is deposited on any type of substrate in the form of films (thickness: 10 to 2000 nm), and (nano)fibers (fiber diameter 10-2000 nm).

An aspect of this invention is to provide 2- and 3-dimensionally patterned substrates composed of a photoresist composition on the basis of at least one of the following group of derivatives: mono-, di-, oligo-, polysaccharide derivatives which bear only one type of acid labile group and a PAG which generates an acid upon exposure by electromagnetic waves and/or charged particle beams; and/or a 2-photon sensitive PAG.

An aspect of this invention is to provide 2- and 3-dimensionally substrates composed of a photoresist composition on the basis of at least one of the following group of derivatives: mono-, di-, oligo-, polysaccharide derivatives which bear only one type of acid labile group and a PAG which generates an acid upon exposure by electromagnetic waves and/or charged particle beams; and a solvent to dissolve the photoresist composition; and/or a 2-photon sensitive PAG.

An aspect of this invention is to provide 2- and 3-dimensionally structured substrates composed of a photoresist composition on the basis of at least one of the following group of derivatives: mono-, di-, oligo-, polysaccharide derivatives which bear only one type of acid labile group and a PAG which generates an acid upon exposure to electromagnetic waves and/or charged particle beams; and treatment with enzymes capable of degrading the exposed photoresist composition; and/or a 2-photon sensitive PAG.

An aspect of this invention is to provide 2- and 3-dimensionally structured substrates composed of a photoresist composition on the basis of at least one of the following group of derivatives: mono-, di-, oligo-, polysaccharide derivatives which bear only one type of acid labile group and a PAG which generates an acid upon exposure by electromagnetic waves and/or charged particle beams; and/or a 2-photon sensitive PAG; and enzymes capable of degrading the exposed photoresist composition, followed by a conversion of the unexposed photoresist composition using acid vapor and or electromagnetic waves and/or charged particle beams.

A resulting aspect of the invention is to provide materials for optical applications such as waveguides due to the change of refractive index of the photoresist composition on the basis of at least one of the following group of derivatives: mono-, di-, oligo-, polysaccharide derivatives which bear only one type of acid labile group and a PAG which generates an acid upon exposure by electromagnetic waves and/or charged particle beams.

A resulting aspect of the invention is to provide patterned substrates for medical applications such as templates for stem cell growth of the photoresist composition on the basis of at least one of the following group of derivatives: mono-, di-, oligo-, polysaccharide derivatives which bear only one type of acid labile group and a PAG which generates an acid upon exposure by electromagnetic waves and/or charged particle beams; and a 2-photon sensitive PAG.

A resulting aspect of the invention is to provide patterned substrates for optical applications such as waveguides due to the change of refractive index of thc photoresist composition on the basis of at least one of the following group of derivatives: mono-, di-, oligo-, polysaccharide derivatives which bear only one type of acid labile group and a PAG which generates an acid upon exposure by electromagnetic waves and/or charged particle beams; and a 2-photon sensitive PAG.

A resulting aspect of the invention is to provide devices with integrated circuits which can be created from the photoresist composition on the basis of at least one of the following group of derivatives: mono-, di-, oligo-, polysaccharide derivatives which bear only one type of acid labile group and a PAG which generates an acid upon exposure by electromagnetic waves and/or charged particle beams.

### Detailed description of the preferred embodiments

The preferred embodiments of the inventions relate to the use of polysaccharide derivatives bearing only a single type of acid labile functional group, in particular silyl ethers (e.g. trimethylsilyl, tert-butyldimethylsilyl, thexylsilyl, trimethylsilyl, tripropylsilyl etc.) of cellulose, chitin and chitosan and other polysaccharides for the creation of 2- and 3-dimensionally micro- and nanostructured photoresist compositions. The solubility of these derivatives is strongly influenced by the degree of substitution with silyl groups and covers alcohols, ketones, ethers, esters, amides, lactams, sulfoxides and aliphatic/aromatic hydrocarbons. Prior to deposition on a substrate (e.g. semiconductor surfaces such as silicon wafers) which is done e.g. by spin coating (creation of films) or electrospinning (creation of (nano)fibers), a photo acid generator which generates acid upon exposure to electromagnetic radiation or particle beams is added to solutions containing the polysaccharide derivatives. After application on a surface in the form of thin films and (nano)fibers, a 2-D photopatterning can be performed using lithographic masks, projection lithography or direct laser writing. In areas which have been exposed to the electromagnetic radiation the generated acid leads to a cleavage of the acid labile group and thus to the formation of polysaccharide (e.g. cellulose, chitin, chitosan) which is insoluble in common organic solvents and water while leaving unexposed areas untouched. A thermal treatment after the exposure to electromagnetic radiation ("post-exposure baking") can enhance the rate of this cleavage reaction. At this stage, there are two major pathways for the creation of a photo and negative resist. On one hand, the unexposed areas which contain the e.g. silylated polysaccharide can be dissolved in a solvent capable of dissolving the derivatives with a chosen DS_{Si} and a negative resist is obtained. On the other hand, the polysaccharides can be removed by the appropriate enzymes (e.g. cellulases, chitinases, chitosanases) capable of degrading the corresponding polysaccharides while leaving the silylated polysaccharide derivatives untouched since the chosen enzymes are not able to digest silylated polysaccharide derivatives. After conversion of the remaining silylated polysaccharide derivatives to the polysaccharides by exposure to acid vapors (e.g. dry HCl) a positive resist is obtained. Both, the positive and the negative resist can be subjected to a dry etching procedure.

In addition also a 3-D structuring can be performed using 2-photon-absorption lithography. For this purpose, the PAG is replaced by a 2-photon sensitive photo acid generator which is excited using a focused laser beam giving a high spatial resolution. In the focus of the light beam, the silyl groups are cleaved off generating the polysaccharide. Using this procedure, it is possible to create 3-D structures since the focus of the radiation source can be located on the surface but also in the bulk where pockets, voids and channels can be created. The size of these structures can be controlled in a range from a few nanometers to 2000 nanometers.

In a similar manner, it is also possible to employ a 2-D structuring in a first step as described above and then a second 3-D structuring step by employing 2-photon absorption lithography. For this approach a 2-photon sensitive photo acid generator must be already present in the material during the 2-D structuring.

The molecular weight of the polysaccharide derivatives should be in the range from 10000 and 1000000 g/mol. In order to prevent a degradation of the polysaccharide backbone, all photolithographic steps should be preferably performed under an inert atmosphere (e.g. dry nitrogen, argon) or at high vacuum. The concentration of the PAG/2-photon sensitive PAG in the photoresist composition can be varied between 0.1 and 50 wt%.

In the following examples of (2-photon-sensitive) photoacid generators (PAGs), that can be used for that purpose, are given:
a.) Ionic photoacid generators which comprise, but are not limited to:
   Onium salts of aryldiazonium, diaryliodonium (e.g. Cyracurc UV1-6976, Esacure 1064,QL Cure 211), triarylsulfonium (e.g. Omnicat 440, Irgacure 250, Rhodorsil 207), triarylselenonium and triarylphosphonium salts that contain complex halides such as BF₄⁻, SbF₆⁻, AsF₆⁻, B(C₆F₅)₄⁻ and PF₆⁻ as counter ions.
   Iron arene complexes (e.g. Irgacure 261) that contain complex halides such as BF₄⁻, SbF₆⁻, ASF₆⁻, B(C₆F₅)₄⁻ and PF₆⁻ as counter ions.
   Dialkylphenacyl sulfonium salts that contain complex halides such as BF₄⁻, SbF₆⁻, AsF₆⁻, B(C₆F₅)₄⁻ and PF₆⁻ as counter ions.
b.) Non-ionic photoacid generators which comprise, but are not limited to: 2-Nitrobenzylester of carboxylic acids,
   2-Nitrobenzylester of sulfonic acids,
   Sulfones compounds which generate sulfinic acid upon UV irradiation Triarylphosphates
   N-Hydroxyimide sulfonates (e.g. N-Hydroxy-5-norbomene-2,3-dicarboximide perfluoro-1-butanesulfonate)
   Sulfonic acid esters of phenol
   Diazonaphthoquinones
   Imino sulfonates
   Trichloromethyl-1,3,5-triazines (e.g. 2-(4-Methoxystyryl)-4,6-bis(trichloromethyl)-1,3,5-triazine)

### Example 1

1. A hydrophobic cellulose derivative bearing only a single type of acid labile functional group (e.g. trimethylsilyl cellulose) containing a PAG is deposited onto a flat substrate.
2. Photolithography using masks in inert atmosphere (e.g. N₂) to avoid degradation of cellulose. Exposed areas are converted into cellulose.
3a. Using a solvent capable of dissolving the cellulose derivative: A negative resist composed of cellulose is obtained.
3b. Application of cellulose digesting enzymes lead to structured cellulose derivative films (e.g. trimethylsilyl cellulose) yielding a positive resist.
4. Application of 2-photon absorption lithography of the films described in 3a and 3b leads to 3-D structured surfaces by regeneration in the focus of a light beam.

### Example 2

1. A hydrophobic chitin derivative bearing only a single type of acid labile functional group (e.g. trimethylsilyl chitin) containing a PAG is deposited onto a flat substrate.
2. Photolithography using masks. Exposed areas are converted into chitin.
3a. Using a solvent capable of dissolving the chitin derivative: A negative resist composed of chitin is obtained.
3b. Application of chitin digesting enzymes (chitinases) leads to structured chitin derivative films (e.g. trimethylsilyl chitin) yielding a positive resist.
4. Application of 2-photon absorption lithography of the films described in 3a and 3b leads to 3-D structured surfaces

### Example 3

1. A hydrophobic cellulose derivative bearing only a single type of acid labile functional group (e.g. trimethylsilyl cellulose) containing a 2-photon sensitive PAG is deposited onto a flat substrate.
2. Application of 2-photon absorption lithography of the films described leads to 3-D structured surfaces

### Example 4

1. A hydrophobic cellulose derivative bearing only a single type of acid labile functional group (e.g. trimethylsilyl cellulose) containing a 2-photon sensitive PAG is knife casted yielding films between 500 and 2000 nm
2. Application of 2-photon absorption lithography of the films described leads to 3-D structured surfaces

## Claims

1. Multidimensionally photopatterned substrate, said multidimensionally photopatterned substrate comprising 2 and/or 3 dimensionally patterned photoresist, said photoresist preferably comprising at least one component chosen from: monosaccharide derivative, its oligomer, its polymer, said multidimensionally photopatterned substrate comprised of at least one photoresist composition on the basis of at least one component chosen from: monosaccharide derivative, disaccharide derivative, oligosaccharide derivative, polysaccharide derivative, said derivative bearing at least one type of acid labile group, and further comprised of a photoacid generator (hereinafter PAG), wherein said substrate is comprised of silyl ether of any of the following: monosaccharide, disaccharide, oligosaccharide, polysaccharide, said substrate changing its refractive index upon conversion to the polysaccharide.

2. Multidimensionally photopatterned substrate according to claim 1 wherein PAG generates an acid upon exposure to electromagnetic waves and/or charged particle beams.

3. Multidimensionally photopatterned substrate according to claim 1 wherein PAG is a 2-photon sensitive PAG.

4. Multidimensionally photopatterned substrate according to any of previous claims wherein photoresist is hydrophobic polysaccharide derivative.

5. Multidimensionally photopatterned substrate according to claim 4 wherein hydrophobic polysaccharide derivative is a chitin.

6. Multidimensionally photopatterned substrate according to claim 4 wherein hydrophobic polysaccharide derivative is a cellulose.

7. Multidimensionally photopatterned substrate according to any of previous claims used for medical applications, preferably as templates for stem cell growth on said substrate or plurality thereof.

8. Multidimensionally photopatterned substrate according to any of previous claims used for the design and manufacturing of devices with integrated circuits.

9. Method for photopatterning multidimensionally photopatterned substrate according to any of claims 1-8, said multidimensionally photopatterned substrate comprising 2 and/or 3 dimensionally patterned substrate, said method comprising at least the following steps:
- a photoresist bearing only a single type of acid labile functional group comprising a PAG is deposited onto a flat substrate;
- execution of photolithography using masks with exposed areas converted into polysaccharide;
- formation of films, said formation comprised of the following steps:
o Use of solvent capable of dissolving polysaccharide derivative to obtain a negative resist composed of polysaccharide;
o Application of polysaccharide digesting enzymes leading to structured polysaccharide derivative films yielding a positive resist;
application of 2-photon absorption lithography of said films leading to 3-D structured surfaces

10. Method according to claim 9 wherein a solvent is used to partially dissolve the photoresist composition.

11. Method according to claim 9 wherein enzymatic treatment is used to degrade the exposed photoresist composition.

12. Method according to any of the claims 9 to 11 wherein unexposed photoresist composition is conversed using acid vapor and or electromagnetic waves and/or charged particle beams.

13. Method according to any of the claims 9 to 12 wherein at least one PAG is chosen from the group comprised of Onium salts of aryldiazonium, diaryliodonium (e.g. Cyracure UVI-6976, Esacure 1064,QL Cure 211), triarylsulfonium (e.g. Omnicat 440, Irgacure 250, Rhodorsil 207), triarylselenonium and triarylphosphonium salts that contain complex halides such as BF₄⁻, SbF₆⁻, AsF₆⁻, B(C₆F₅)₄⁻ and PF₆⁻ as counter ions, Iron arene complexes (e.g. Irgacure 261) that contain complex halides such as BF₄⁻, SbF₆⁻, AsF₆⁻, B(C₆F₅)₄⁻ and PF₆⁻ as counter ions, Dialkylphenacyl sulfonium salts that contain complex halides such as BF₄⁻, SbF₆⁻, AsF₆⁻, B(C₆F₅)₄⁻ and PF₆⁻ as counter ions, 2-Nitrobenzylester of carboxylic acids, 2-Nitrobenzylester of sulfonic acids, Sulfones compounds which generate sulfinic acid upon UV irradiation, Triarylphosphates, N-Hydroxyimide sulfonates (e.g. N-Hydroxy-5-norbornene-2,3-dicarboximide perfluoro-l-butanesulfonate), Sulfonic acid esters of phenol, Diazonaphthoquinones, Imino sulfonates, Trichloromethyl-1,3,5-triazines (e.g. 2-(4-Methoxystyryl)-4,6-bis(trichloromethyl)-1,3,5-triazine).

## Patentansprüche

1. Ein multidimensional photostrukturiertes Substrat, dieses multidimensional photostrukturierte Substrat umfassend 2- und/oder 3-dimensional strukturierte Photoresiste, diese Photoresiste vorzugsweise umfassend mindestens eine Komponente, ausgewählt aus: Derivat eines Monosaccharids, seinem Oligomer, seinem Polymer, dieses multidimensional photostrukturierte Substrat umfassend mindestens eine Photoresistzusammensetzung auf Grundlage mindestens einer Komponente, ausgewählt aus: Derivat eines Monosaccharids, Derivat eines Disaccharides, Derivat eines Oligosaccharids, Derivat eines Polysaccharids, wobei dieses Derivat mindestens eine säurelabile Gruppe trägt und ferner umfassend einen Photosäuregenerator (im Folgenden als "PAG" bezeichnet), wobei dieses Substrat Silylether von einem der Folgenden umfasst: Monosaccharid, Disaccharid, Oligosaccharid, Polysaccharid, wobei dieses Substrat seinen Refraktionsindex nach Umwandlung in das Polysaccharid verändert.

2. Ein multidimensional photostrukturiertes Substrat nach Anspruch 1, wobei der PAG eine Säure nach Exposition gegenüber elektromagnetischen Wellen und/oder geladenen Teilchenstrahlen erzeugt.

3. Ein multidimensional photostrukturiertes Substrat nach Anspruch 1, wobei der PAG ein Zwei-Photonen-sensitiver PAG ist.

4. Ein multidimensional photostrukturiertes Substrat nach einem der vorstehenden Ansprüche, wobei das Photoresist ein hydrophobes Derivat eines Polysaccharids ist.

5. Ein multidimensional photostrukturiertes Substrat nach Anspruch 4, wobei das hydrophobe Derivat eines Polysaccharids Chitin ist.

6. Ein multidimensional photostrukturiertes Substrat nach Anspruch 4, wobei das hydrophobe Derivat eines Polysaccharids Cellulose ist.

7. Ein multidimensional photostrukturiertes Substrat nach einem der vorstehenden Ansprüche zum Verwenden für medizinische Anwendungen, vorzugsweise als Matrizen für das Stammzellenwachstum auf diesem Substrat oder einer Vielzahl davon.

8. Ein multidimensional photostrukturiertes Substrat nach einem der vorstehenden Ansprüche zum Verwenden für das Design und die Herstellung von Geräten mit integrierten Schaltungen.

9. Verfahren zum Photostrukturieren eines multidimensional photostrukturierten Substrats nach einem der Ansprüche 1-8, dieses multidimensional photostrukturierte Substrat umfassend 2- und/oder 3-dimensional strukturierte Photoresiste, dieses Verfahren umfassend mindestens die folgenden Schritte:
- ein Photoresist, das nur einen einzelnen Typ einer säurelabilen Funktionsgruppe trägt und einen PAG umfasst, der auf einem flachen Substrat abgelagert ist;
- Ausführung von Photolithographie unter Verwendung von Photomasken mit exponierten, in Polysaccharid umgewandelten Bereichen;
- Bildung von Filmen, wobei diese Bildung die folgenden Schritte umfasst:
∘ Verwendung eines zum Auflösen des Derivats eines Polysaccharids fähigen Lösemittel, um ein negatives, aus Polysaccharid bestehendes Resist zu erhalten;
∘ Anwendung von polysaccharidabbauenden Enzymen, wodurch sich strukturierte Derivatfilme eines Polysaccharids ergeben, die ein positives Resist liefern; Anwendung einer Zwei-Photonen-Absorptionslithographie dieser Filme, wodurch sie strukturierte 3D-Oberflächen ergeben

10. Verfahren nach Anspruch 9, wobei ein Lösemittel verwendet wird, um die Photoresistzusammensetzung teilweise aufzulösen.

11. Verfahren nach Anspruch 9, wobei eine Enzymbehandlung verwendet wird, um die exponierte Photoresistzusammensetzung abzubauen.

12. Verfahren nach einem der Ansprüche 9 bis 11, wobei die nicht exponierte Photoresistzusammensetzung unter Verwendung von Säuredampf und/oder elektromagnetischen Wellen und/oder geladenen Teilchenstrahlen umgewandelt wird.

13. Verfahren nach einem der Ansprüche 9 bis 12, wobei mindestens ein PAG ausgewählt ist aus der Gruppe umfassend Oniumsalze vom Typ Aryldiazonium-, Diaryljodonium- (z. B. Cyracure UVI-6976, Esacure 1064, QL Cure 211), Triarylsulfonium- (z. B. Omnicat 440, Irgacure 250, Rhodorsil 207), Triarylselenonium- und Triarylphosphoniumsalze, die komplexe Halide, wie etwa BF₄⁻, SbF₆⁻, AsF₆⁻, B(C₆F₅)₄⁻ und PF₆⁻, als Gegenionen enthalten, Eisenarenkomplexe (z. B. Irgacure 261), die komplexe Halide, wie etwa BF₄⁻, SbF₆⁻, AsF₆⁻, B(C₆F₅)₄⁻ und PF₆⁻, als Gegenionen enthalten, Dialkylphenacylsulfonsalze, die komplexe Halide, wie etwa BF₄⁻, SbF₆⁻, AsF₆⁻, B(C₆F₅)₄⁻ und PF₆⁻, als Gegenionen enthalten, 2-Nitrobenzylester von Carbonsäuren, 2-Nitrobenzylester von Sulfonsäuren, Sulfonverbindungen, die Sulfinsäure nach UV-Bestrahlung erzeugen, Triarylphosphate, N-Hydroxyimidsulfonate (z. B. N-Hydroxy-5-norbornen-2,3-dicarboximid-perfluoro-1-butansulfonat), Sulfonsäureester von Phenol, Diazonaphthoquinone, Iminosulfonate, Trichloromethyl-1,3,5-triazine (z. B. 2-(4-Methoxystyryl-)4,6-bis(trichloromethyl)-1,3,5-triazin).

## Revendications

1. Substrat à photomotifs multidimensionnels, ledit substrat à photomotifs multidimensionnels comprenant 2 et/ou 3 photorésists à motifs dimensionnels, ledit photorésist comprenant de préférence au moins un composant sélectionné parmi : un dérivé de monosaccharide, son oligomère, son polymère, ledit substrat à photomotifs multidimensionnels étant composé d'au moins une composition photorésist sur la base d'au moins un composant sélectionné parmi :
un dérivé de monosaccharide, un dérivé de disaccharide, un dérivé d'oligosaccharide, un dérivé de polysaccharide, ledit dérivé portant au moins un type de groupe labile acide, et composé en outre d'un générateur de photoacide (désigné ci-après PAG), où ledit substrat se compose d'un éther de silyle de l'un des éléments suivants: monosaccharide, disaccharide, oligosaccharide, polysaccharide, ledit substrat changeant son indice de réfraction pendant la conversion du polysaccharide.

2. Substrat à photomotifs multidimensionnels selon la revendication 1, où le PAG génère un acide en cas d'exposition à des ondes électromagnétiques et/ou des faisceaux de particules chargés.

3. Substrat à photomotifs multidimensionnels selon la revendication 1, où le PAG est un PAG sensible à 2 photons.

4. Substrat à photomotifs multidimensionnels selon l'une des revendications précédentes, où le photorésist est un dérivé de polysaccharide hydrophobe.

5. Substrat à photomotifs multidimensionnels selon la revendication 4, où le dérivé de polysaccharide hydrophobe est une chitine.

6. Substrat à photomotifs multidimensionnels selon la revendication 4, où le dérivé de polysaccharide hydrophobe est une cellulose.

7. Substrat à photomotifs multidimensionnels selon l'une des revendications précédentes utilisé pour des applications médicales, de préférence en tant que gabarits pour la croissance de cellules souches sur ledit substrat ou une pluralité de ceux-ci.

8. Substrat à photomotifs multidimensionnels selon l'une des revendications précédentes utilisé pour la conception et la fabrication de dispositifs à circuits intégrés.

9. Procédé de photomodélisation d'un substrat à photomotifs multidimensionnels selon l'une des revendications 1-8, ledit substrat à photomotifs multidimensionnels comprenant 2 et/ou 3 photorésists à motifs dimensionnels, ledit procédé comprenant au moins les étapes suivantes :
- un photorésist ne portant qu'un seul type de groupe fonctionnel labile acide comprenant un PAG est déposé sur un substrat plat ;
- l'exécution de photolithographie utilisant des masques avec des zones exposées converties en polysaccharide ;
- le formation de films, ladite formation comprenant les phases suivantes :
∘ l'utilisation d'un solvant capable de dissoudre un dérivé de polysaccharide pour obtenir un résist négatif composé de polysaccharide ;
∘ l'application d'enzymes de digestion de polysaccharide avec pour conséquence que les films de dérivé de polysaccharide structuré produiront un résist positif ;
l'application d'une lithographie par absorption à 2 photons desdits films pour obtenir des surfaces structurées en 3 dimensions

10. Procédé selon la revendication 9, où l'on utilise un solvant pout dissoudre partiellement la composition photorésist.

11. Procédé selon la revendication 9, où le traitement enzymatique permet de dégrader la composition photorésist exposée.

12. Procédé selon l'une quelconque des revendications 9 à 11, où la composition photorésist non exposée est convertie par vapeur d'acide et/ou des ondes électromagnétiques et/ou des faisceaux de particules chargés.

13. Procédé selon l'une quelconque des revendications 9 à 12, où au moins le PAG est sélectionné parmi le groupe composé de sels d'onium d'aryldiazonium, de sels de diaryliodonium (par exemple Cyracure UVI-6976, Esacure 1064,QL Cure 211), de triarylsulfonium (par exemple Omnicat 440, Irgacure 250, Rhodorsil 207), de triarylsélénonium et de triarylphosphonium contenant des halogénures complexes comme BF₄⁻, SbF₆⁻, AsF₆⁻, B(C₆F₅)₄⁻, er PF₆⁻, comme contre-ions, des complexes d'arène de fer (comme Irgacure 261) contenant des halogénures complexes comme BF₄⁻, SbF₆⁻, AsF₆⁻, B(C₆F₅)₄⁻ et PF₆⁻ comme contre-ions, des sels de dialkylphénacylsulfonium contenant des halogénures complexes comme BF₄⁻, SbF₆⁻, AsF₆⁻, B(C₆F₅)₄⁻ et PF₆⁻ comme contre-ions, l'ester 2-nitrobenzylique d'acides carboxyliques, l'ester 2-nitrobenzylique d'acides sulfoniques, les composés sulfonés générant de l'acide sulfinique pendant une irradiation UV, les triarylphosphates, les sulfonates de N-hydroxyimide (par exemple le sulfonate de 'N'-Hydroxy-5-norbornene-2,3-dicarboximide perfluoro-1-butane), les esters d'acide sulfonique de phénol, les diazonaphtoquinones, les imino sulfonates, les 1,3,5-triazines de trichlorométhyle (par exemple la 1,3,5 triazine de 2-(4-méthoxystyryle)-4,6-bis(trichlorométhyle).
